# EUROPEAN PATENT SPECIFICATION

(11) **EP 0 417 345 B1**
(45) Date of publication and mention of the grant of the patent: **24.07.1996**
(21) Application number: 89117072.2
(22) Date of filing: 15.09.1989
(51) Int. Cl.: H01L 23/538, H01L 23/14

(54) **Design method for VLSI chips arranged on a carrier and module thus designed**
Designmethode für auf einem Träger angeordnete VLSI-Chips und resultierender Modul
Méthode de configuration pour puces VLSI arrangées sur un substrat et module en résultant

(43) Date of publication of application: 20.03.1991
(73) Proprietor: International Business Machines Corporation, Armonk, N.Y. 10504 (US)
(72) Inventor: Schettler, Helmut, Dipl.-Ing., D-7405 Dettenhausen (DE); Schulz, Uwe, D-7030 Böblingen (DE); Zühlke, Rainer, Dr.-Ing., D-7052 Leonberg-Warmbronn (DE)
(74) Representative: Rach, Werner, Dr.

(56) References cited:
- EP-A- 0 007 993
- EP-A- 0 067 677
- EP-A- 0 271 596
- AT&T TECHNICAL JOURNAL, vol. 66, no. 4, August 1987, pp. 31-44, Short Hills, NJ, US; C.A. GIFFELS et al.: "interconnection media"
- IBM TECHNICAL DISCLOSURE BULLETIN, vol. 30, no. 2, July 1987, pp. 693-695, New York, US; "Complementary mosaic packaging concept"
- IBM TECHNICAL DISCLOSURE BULLETIN, vol. 19, no. 9, February 1977, page 3427, New York, US; C. VICARY: "Voltage distribution technique for an automatically designed logic chip"
- PATENT ABSTRACTS OF JAPAN, vol. 10, no. 263 (E-435)[2319] & JP-A-61 089 658

## Description

The invention relates to a design method for electrical circuitry contained on very large scale integrated (VLSI) semiconductor chips that are packaged on a carrier medium of a higher package level containing the necessary connection lines, and a module especially designed in accordance with this design method.

The design of chips and the design of packages carrying the chips up to now has been almost independent from each other. First the chips go through physical design. They are optimized just to the chip optimum. After the chip design has been finished the design of the chip interconnect medium that means the carrier could be started. This carrier could be multichip module or a card.

The result then ultimately is a complex wiring on the chip carrier. This causes wiring congestions and long wires. Those long wires are responsible for considerable interconnect delay.

This design concept is good enough to yield optimized chips and to yield optimized cards, but it is by far not good enough to yield an optimized product, that means the optimum for the combination of both.

For the physical VLSI-chip design a method is known that divides in a hierarchical top-down design methodology the circuitry that is to be contained on the chip logically into partitions that are manageable by the present automatic design systems and programs. This method is described in the European patent application EP-A-0 271 596. In accordance with that known method on the chip global wiring connection lines are from the beginning included into the design of the different individual partitions of the chip and there in those partitions they are treated in the same way as circuits in that specific area. The different partitions can now be designed in parallel. A floor plan is established that gives the different partitions a shape in such a way that they fit together without leaving any space between the different individual partitions.

These known method for the physical VLSI-chip design concentrates on the design of the chip itself. It does not take into account or into consideration the design of the carrier onto which it is to be placed or the design of neighbouring chips that have to cooperate with it.

It is the object of the present invention to provide a design method in which from the beginning all electrical circuitry that cooperates in one functional unit and that needs more space than just one single chip, is designed in optimal manner for shortest overall connection line length and optimized overall yield. Furthermore it is an object of the design system of the present invention to provide an optimized product, including an optimized chip and an optimized carrier in that sense that both together in a combination provide in combination the optimum.

In accordance with the present invention these objects are obtained by a semiconductor thin film multi-chip module in accordance with claim 1 and a manufacturing method as laid down in claim 5 of the present invention. Further advantageous embodiments are laid down in the dependent subclaims.

In advantageous manner this design method integrates the very large scale integration package into the design method already at the initial stage so that the chip boundaries are more or less suppressed and the partition task is alleviated. In an synoptical manner from the beginning the chips and their carrier together are considered in containing the functional unit formed by the electric circuitry. Overall less length of connection lines are possible and also parallel signal transportation on a sort of wider buses is possible over parallel connection lines via the carrier medium that is incorporated into the design from the beginning.

In accordance with a preferred embodiment of the present invention, time-critical paths of the electrical circuitry are provided on one single chip wherever possible. Furthermore as carrier medium of a higher package level preferably a passive silicon carrier PSC is provided that contains the necessary connecting lines for the chips arranged on it. In principal also other carrier means as there are cards or multilayer ceramic modules or multilayer glass modules are possible to be used as a second level carrier medium for the chips.

In connection with the following more specific description of the invention and its different aspects embodiments are described in connection with the drawing. In the drawing there is shown in
- Fig. 1: in top view and cross sectional side view schematically the arrangement and connection of sections of two chips on a section of a passive silicon carrier;
- Fig. 2: schematically two chips adjacent to each other with associately ordered input/output signal contacts vis-a-vis each other;
- Fig. 3: a chip with partitions on it close to associately assigned input/output contacts;
- Fig. 4: a chip foot print with contact pads arranged on it belonging to a section of a chip;
- Fig. 5: schematically the data flow of a multichip processor in arrangement and preparation for the synoptical design in accordance with the present invention;
- Fig. 6: schematically in a top view the arrangement of several multi chip processors parallel to each other on a passive silicon carrier and the main connection buses running over the PSC.

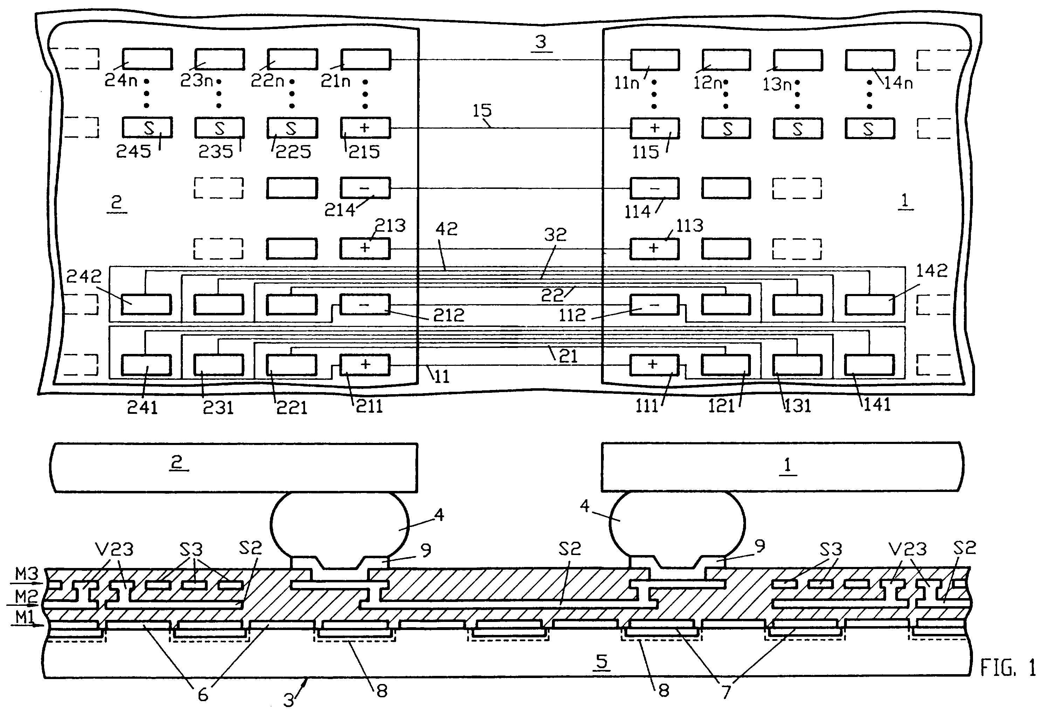

Fig. 1 shows a section of two chips 1 and 2 that are provided on a section of a carrier medium 3. The upper part of Fig. 1 shows this arrangement in top view whereas the lower part shows the arrangement in a cross sectional side view. In this side view it is indicated, that chip 1 and 2 are connected by means of solder balls 4 with the carrier medium 3.

The carrier medium 3 shown in Fig. 1 is a passive silicon carrier (PSC) that is performed in silicon thin film technology. The PSC essentially consists of a substrate 5 on which three metal layers M1, M2 and M3 as well as solder pads 9 are arranged. By those solder pads 9 the connection by means of solder balls 4 is generated to the chips 1 and 2.

In the metal layer M1 there are provided the power lines with lines 6 that lead ground potential and line 7 that carry the voltage. By dotted lines 8 around the areas of the power voltage lines 7 there are provided capacitors for decoupling purposes. Those could be provided by an n+ doped area within a p+ substrate 5. Above the first plane M1, the metal plane 1 which carries the power lines, there is in a second plane M2 provided a set of signal lines S2. Orthogonally arranged thereto is in a third plane above plane M2 a further metal plane M3 in which there are arranged signal lines S3. Between the two planes M2 and M3 there are provided vias V23 that connect certain lines in both planes. The signal lines S2 in plane M2 are essentially parallel to each other and also the signal lines S3 in plane M3 are essentially parallel to each other but orthogonally arranged with respect to the parallel signal lines S2 of plane M2.

The upper part of Fig. 1 shows in the top view on each chip four rows of contact pads that are parallel to each other. They are arranged in the input/output port area of each chip adjacent to the chip edge. The outer most row 111 to 11n of chip 1 and 211 to 21n of chip 2, which both only form a section of the whole pads along the chip edges, are power connections that carry alternatively ground or voltage, indicated by the minus or plus sign. To the inner of each chip there are provided three parallel lines of signal pads 121 to 12n, 131 to 13n and 141 to 14n on chip 1 and 221 to 22n, 231 to 23n and 241 to 24n on chip 2. As can be seen on Fig. 1, signal pad 121 is connected with signal pad 221 by line 21, signal pad 122 is connected to signal pad 222 by line 22 and for example signal pad 132 is connected by line 32 with signal pad 232 and signal pad 142 of chip 1 is connected with signal pad 242 of chip 2 by line 42. Also for example power pad 111 is connected by line 11 with power pad 211 and for example power pad 115 is connected by line 15 with power pad 215. All the connecting lines are parallel to each other and connect the associated pads on the shortest possible way.

Especially upon direct chip to chip connection, each physical line that connects Input/Output contact pads can be procided with shielding physical lines formed by power lines (ground or voltage). In this case, adjacent chips do not contain Input/Output driver/receiver circuits in areas where Input/Output ports are arranged.

In accordance with the design method according to the present invention for gaining an optimal shorter length of the overall length of the connection lines, for example 21, 22, 32, 42 etc. and for improving the overall performance of the finally designed product, in the designing process the complete electrical circuitry, that means the system logic or functional unit, is looked at and considered synoptically. In this synoptical design method the complete circuitry is divided, is partitioned and is placed then on the different semiconductor chips and simultaneously on the carrier medium 3. This dividing, partitioning and placing is preferably done in a top-down methodology in which each chip of said plurality of chips and the package, that means the chips arranged on the carrier, are optimized as a whole, or with other words in a combination. In this overall process of synoptically designing the given electrical circuitry, a minimal number and a minimal length of connection lines between the chips is provided. Furthermore a minimal number of input/output contacts between the chips are provided. Furthermore it is preferable to concentrate time-critical paths on one single chip wherever that is possible.

A further very important feature of the synoptical design method according to the present invention is the input/output ordering on adjacent chips. Corresponding I/O's of different chips are arranged vis-a-vis to each other. In Fig. 1 there is shown, that the signal pads 121 of chip 1 and 221 of chip 2 are opposite to each other. In the same way the signal pad 121 up to 12n of chip 1 is opposite to pads 221 up to 22n of chip 2. The same is true for the row 131 up to 13n opposite to 231 to 23n and the row signal pads 141 to 14n of chip 1 opposite to the signal row 241 to 24n of chip 2.

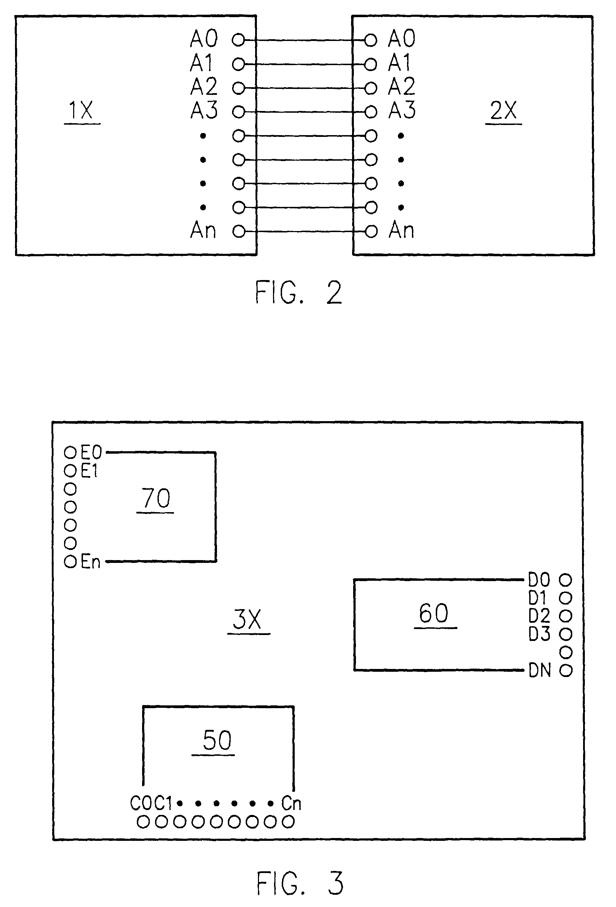

The same feature is shown schematically in the representation of Fig. 2 wherein the data pads A0 to An of chip lx are arranged opposite those denominated with A0 to An of adjacent chip 2x. By this structuring of the input/output contacts vis-a-vis each other the shortest possible connection between two adjacent chips can be reached. Furthermore all the connection lines are parallel to each other and provided in the carrier 3 as shown in Fig. 1. There that signal plane that is closest to the chips is preferably used, i.e. in the shown embodiment by signal lines S3 in plane M3. The connection of the associated pads is thus the shortest possible.

A further important aspect of the synoptical design method in accordance with the present invention is that circuits belonging to associated certain input/output contacts are arranged in partitions of the respective chip as close to the associated I/O's as possible. To that end in Fig. 3 the chip partitioning is shown as a function of the I/O assignment. So for example in chip 3x there are provided I/O's C0 to Cn at the lower edge of chip 3x that are associated with partition 50. Than there is a further partition 60 which is associated and belonging to the I/O's pads D0 to Dn. This partition 60 with the associated I/O is arranged on the right hand side of chip 3x. On the left hand edge there is shown as example a third partition 70 with associated input/output pads E0 to En.

The scheme shown in Fig. 3 makes clear another important aspect of the present invention namely that it is essential to design the single chips more or less from the outside to the inner part of the chip. That means that after the I/O assignment in the input/output port areas of the chips starting from there to the inner of the chip the design is performed. Here then only the chip design is performed in so far as only connections and circuits within the chip are concerned. The electric circuits within a chip are arranged in considering the input/output pads and necessities that are provided in the circumferential areas of said specific chip.

In accordance with the synoptical design method according to the present invention the chips are arranged on the carrier in such a way that between the chips on the carrier the shortest connection lines are possible and also in such a way that the overall length needed for all connection lines is as short as possible. Depending on the kind of carrier used it might be advisably to provide the connection lines predominantly in a certain plane, i.e. in M3 of PSC 3.

In the synoptical top-down design of the present invention advantageously the following main steps are performed:

The logic design, electrical circuitry or functional unit to be designed is divided in partitions that fit on several chips. In doing that chip size and time-critical paths are considered. Having done this, the placement of these chips on the carrier is performed. In doing this minimum wiring length and again timing requirements are observed and decisive factors. Furthermore a preferred routing direction of the wiring might be preferred so that the mass of wiring is placed in a single signal line plane. In the designing according to the invention, the next main step is the I/O contact pad assignment in vis-a-vis ordering on the chips to generate shortest possible connections and/or best timing. In doing the I/O assigning it is preferable to start with the widest buses and go down stepwise up to single lines.

This process of synoptical top-down design can be iterated several times to reach a finally optimal result.

By taking into account all the precedingly stated important aspects of the synoptical top down design method of chips on carrier an optimal product is conceived.

By using a passive silicon carrier as shown in Fig. 1 it is possible to design a semiconductor thin film multichip module of an excellent overall performance with high yield.

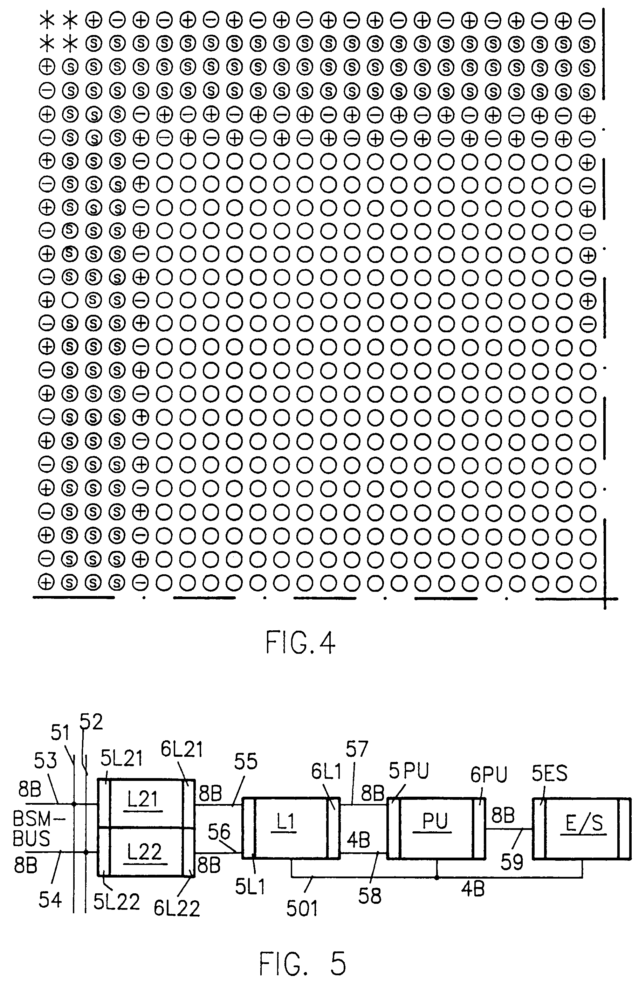

In connecting chips to the passive silicon carrier provided in thin film silicon technology the chips are fixed to the carrier by the so-called flip chip technique by means of soldering technique using solder balls. There, the so-called "C4" technique is used, that means that a collapse controlled chip connection is provided by soldering balls. The area around the chip as already shown in Fig. 1 is preferably used for the input/output pads. The Fig. 4 shows beside those three lines of signal input/output pads in the same way as Fig. 1 the power pads as the outer most line of contact pads. Within the area of the three lines of signal pads there is plenty of room for further contact pads that are used predominantly for power connections with ground and voltage lines. Those are indicated by plus and minus signes in that section of chip which is shown in the schematic top view of a quarter of a chip of Fig. 4. It is easy possible to have about 2500 contact pads on a chip.

The design method in accordance with the present invention can be used for designing chips that are applicable in data processing, in communication and in automotive technique as well as certainly in still further applications where high density electrical functional units are to be applied.

In connection with Fig. 5 one possible application for the present invention is shown in connection with a multichip processor that encompasses five chips. In Fig. 5 the data flow of the multichip processor is prepared for synoptical design.

The multichip processor shown in Fig. 5 is connected to the system memory bus 51, 52 by means of the basic storage module bus 53 and 54. Bus 53 is connected to the left hand I/O port area 5L21 of a first storage chip L21. Likewise bus 54 is connected to an I/O port 5L22 of a second storage chip L22. On the right hand side storage chip L21 has an I/O port 6L21 that is connected by a line 55 to the I/O port area 5L1 of a further storage chip L1. Likewise from the right hand side I/O port area 6L22 of storage L22 a connection line 56 leads to the I/O port area 5L1 of chip L1.

The two storage chips L21 and L22 might have a storage capacity of 128 kB each and be relatively slow, whereas chip L1 might have a capacity of only 64 kB but is a fast cash chip for example. The right hand side of the fast cash chip L1 has an I/O port area 6L1 which is connected via line 57 and via line 58 with left hand I/O port area 5PU of a processor unit chip PU. This chip PU has also a right hand I/O port area 6PU which is connected via line 59 with a left hand I/O port area 5ES of a further chip E/S. This chip E/S can be an engineering and scientific processor unit chip. As can be seen from the drawing, chip L1 is furthermore connected via line 501 with chip PU and chip E/S.

The indication "8B" and "4B" along the different lines 53, 54, 55, 56, 57, 58, 59, 501 indicate the width of the connection. That means that for example line 55 has the width of 8 Byte that means that there are 8 times 9 physical connection lines necessary to form line 55. On the other hand there have to be in the I/O port area 6L1 as well as in the I/O port area 5L1 on each side 144 connection pads. The lines 58 and 501 are 4 Bytes wide, that means that 36 physical lines have to be provided in the carrier medium and corresponding 36 I/O contact pads have to be provided on both ends of this lines that means in the other chips L1, PU, E/S, for line 501 and in the I/O port areas 6L1 and of chip L1 and 5PU of chip PU. All those lines with the 4B or 8B indication aside it are merly signal lines.

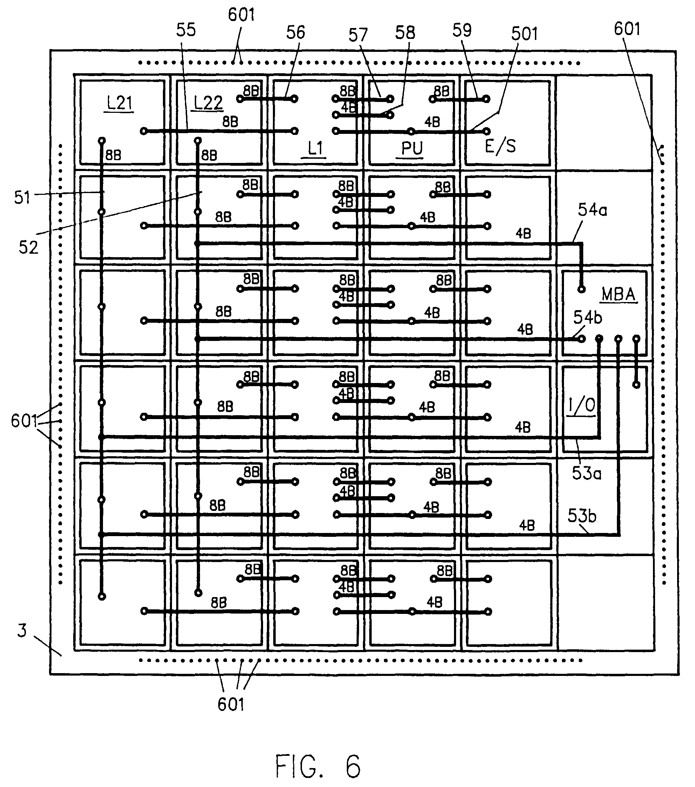

Fig. 6 shows schematically the assembling and the wiring of several multichip processors arranged in parallel on a carrier 3, preferably a thin film passive silicon carrier. In the upper row of Fig. 6 there are shown from left to right chip L21, L22, L1, PU and E/S. The sixth position to the right is empty. As can be seen from Fig.6, between the chips there is a slight distance but not very far. This distance is provided so that the chips could be removed from carrier 3 in case of malfunction. The thick lines between the chips represent again the connections. So they are designated with the same numbers as in the data flow representation of Fig. 5. The thick circles represent a connection between the chip and the underlaying carrier 3. So for example line 55 represents the 8 Byte wide connection between chip L21 and chip L1 crossing underneath chip L22. Line 56 connects chip L22 and chip L1 and represents also an 8 Byte wide connection with 72 physical lines that run from chip L22 down to carrier 3 and up again to chip L1, on each side in adjacent I/O port areas. Parallel to the processor in the first upper line there are provided 5 more or less identical processors in line two to six below. On the right hand side in the third and fourth line there are provided additional chips. There is provided in the third line chip MBA as a memory bus adapter chip and below that one there is provided an I/O chip for controlling the Input/Output channals of the assembly

As furthermore can be seen from Fig. 6 in the edge area on all four edges of carrier 3 there are provided contact bumps 601 that connect the carrier 3 with its contained chips with the outside. This outside might be a simple card or another simple carrier which is not shown in Fig. 6.

Fig. 6 shows that the chips placed on carrier 3 are connected among each other by two-dimensional lines. Those lines predominantly are placed in only one metal plane. Those are the lines running from left to right. The other vertical lines are in the second metal plane for the other signal lines.

This scheme used in reaching an arrangement as shown in Fig. 6 allows that the wiring in the passive silicon carrier 3 is done very completely in one layer of metal only, preferably metal layer 3 M3. Only a few wire crossing is required to go to the second plane of signal layers metal layer M2. This scheme helps a lot to reduce the wire capacity and to increase the yield. As only a few under paths are on M2 whereas most wires are parallel on M3.

## Claims

1. Semiconductor thin film multichip module, containing a plurality of semiconductor chips (1,2) on a semiconductor, preferably silicon, carrier (3) for providing chip to chip connection, wherein
a) corresponding contacts (111, 211; ...; 11n, 21n; ...; 141, 241; ...; 14n, 24n) of adjacent chips (1, 2) are arranged opposite to each other,
b) said corresponding contacts are connected by parallel lines (11, 21, 22, 32, 42, 15) via the semiconductor carrier (3), and
c) signal Input/Output contacts are arranged in areas adjacent to the circumferential edges of the chips,
whereby said chips are provided with contact pads on the complete chip surface and
whereby the outermost row of contact pads contains power contacts connected to a first metal layer (M1) of said semiconductor carrier, and subsequent rows toward the center of the chip are provided as signal Input/Output contact pads, connected to a second (M2) or third (M3) metal layer of said semiconductor carrier.

2. Semiconductor thin film multichip module according to claim 1, wherein all contact pads within the area surrounded by said subsequent rows of signal I/O's contact pads are provided as power contact pads either for ground or voltage.

3. Semiconductor thin film multichip module according to claim 1 or 2, wherein each physical line that connects signal Input/Output contact pads is provided with shielding physical lines formed by power lines that can be ground or voltage, especially upon direct chip to chip connection.

4. Semiconductor thin film multichip module according to claim 3, wherein upon direct chip to chip connection of adjacent chips the latter do not contain Input/Output driver/receiver circuits in areas where Input/Output ports are arranged.

5. A method of manufacturing a semiconductor thin film multichip module according to any one of claims 1 to 4, comprising
designing the chips, including the steps of
logically dividing and partitioning the circuitry to be placed on the different semiconductor chips,
placing said divided and partitioned circuitry on the different semiconductor chips and simultaneously on said carrier, thereby arranging corresponding Input/Output contacts of different chips opposite to each other,
connecting said corresponding Input/Output contacts by parallel lines via the semiconductor carrier, and
arranging signal Input/Output contact in circumferential edge areas of the chip.

6. Method according to claim 5, wherein said chips are packaged on a passive silicon carrier containing the necessary connecting lines (S2, S3, V23) for the chips arranged on it.

7. Method according to claim 6, further comprising providing said carrier in thin film technology containing essentially power lines (6, 7) in a first plane (metal layer 1, M1), a first set of signal lines (S2) in a second plane (metal layer 2, M2), a second set of signal lines (S3) in a third plane (metal layer 3, M3), said first and said second sets of signal lines (S2, S3) arranged essentially orthogonally to each other, and vias (V23) for connecting at appropriate locations a signal line of said first set (S2) with a signal line of said second set (S3).

8. Method according to any one of claims 5 to 8, wherein in top-down methodology simultaneously each chip of said plurality of chips and said package - given by all chips arranged on the carrier medium - are optimized.

## Patentansprüche

1. Halbleiterdünnschicht-Mehrchipmodul, das eine Vielzahl von Halbleiterchips (1, 2) auf einem Halbleiterträger (3), vorzugsweise Silicium, für den Anschluß zwischen den Chips enthält, wobei
a) entsprechende Kontakte (111, 211; ...; 11n, 21n; ...; 141, 241; ...; 14n, 24n;) von benachbarten Chips (1, 2) einander gegenüberliegend angeordnet sind,
b) die entsprechenden Kontakte durch parallele Leitungen (11, 21, 22, 32, 42, 15) über den Halbleiterträger (3) verbunden sind, und
c) Signaleingabe/-ausgabekontakte in Bereichen angeordnet sind, die an den peripheren Kanten der Chips liegen,
wodurch die Chips auf der fertigen Chipoberfläche mit Kontaktflecken versehen sind und
wodurch die am weitesten außen liegende Reihe von Kontaktflecken Stromversorgungskontakte enthält, die mit einer ersten Metallschicht (M1) des Halbleiterträgers verbunden sind, und in Richtung auf die Chipmitte folgende Reihen als Kontaktflecken für Signaleingabe/-ausgabe vorgesehen sind, wobei diese mit einer zweiten (M2) oder dritten (M3) Metallschicht des Halbleiterträgers verbunden sind.

2. Halbleiterdünnschicht-Mehrchipmodul gemäß Anspruch 1, wobei alle Kontaktflecken innerhalb des Bereiches, der von den aufeinanderfolgenden Reihen von Signal-E/A-Kontaktflecken umgeben ist, als Stromversorgungskontakte entweder für Masse oder Spannung vorgesehen sind.

3. Halbleiterdünnschicht-Mehrchipmodul gemäß Anspruch 1 oder 2, wobei jede physische Leitung, die Signaleingabe-/ausgabekontaktflecken verbindet, mit abschirmenden physischen Leitungen versehen ist, die aus Stromversorgungsleitungen gebildet werden, die Masse oder Spannung führen können, insbesondere bei direktem Anschluß der Chips untereinander.

4. Halbleiterdünnschicht-Mehrchipmodul gemäß Anspruch 3, wobei bei direkter Verbindung der Chips untereinander bei benachbarten Chips die letzteren keine Eingabe-/Ausgabe-Treiber-/Empfängerschaltungen in Bereichen enthalten, in denen Eingabe-/Ausgabeanschlüsse angeordnet sind.

5. Verfahren zum Herstellen eines Halbleiterdünnschicht-Mehrchipmoduls gemäß einem beliebigen der Ansprüche 1 bis 4, umfassend
Entwerfen der Chips einschließlich der Schritte des
logischen Aufteilens und Unterteilens der Schaltung, die auf den verschiedenen Halbleiterchips angeordnet werden soll,
Unterbringen der aufgeteilten und unterteilten Schaltung auf den verschiedenen Halbleiterchips und gleichzeitig auf dem Träger, wobei entsprechende Eingabe-/Ausgabekontakte der verschiedenen Chips einander gegenüberliegend angeordnet werden,
Verbinden der entsprechenden Eingabe-/Ausgabekontakte durch parallele Leitungen über den Halbleiterträger, und
Anordnen von Signaleingabe-/-ausgabekontakten in peripheren Kantenbereichen des Chips.

6. Verfahren gemäß Anspruch 5, wobei die Chips auf einem passiven Siliciumträger gepackt sind, der die notwendigen Anschlußleitungen (S2, S3, V23) für die auf ihm angeordneten Chips enthält.

7. Verfahren gemäß Anspruch 6, das weiterhin das Ausstatten des Trägers in Dünnschichttechnologie in der Art umfaßt, daß er im wesentlichen Stromversorgungsleitungen (6, 7) in einer ersten Ebene (Metallschicht 1, M1), eine erste Gruppe von Signalleitungen (S2) in einer zweiten Ebene (Metallschicht 2, M2), eine zweite Gruppe von Signalleitungen (S3) in einer dritten Ebene (Metallschicht 3, M3), wobei die ersten und die zweiten Gruppen der Signalleitungen (S2, S3) im wesentlichen rechtwinklig zueinander angeordnet sind, und Kontaktlöcher (V23) zum Verbinden einer Signalleitung der ersten Gruppe (S2) mit einer Signalleitung der zweiten Gruppe (S3) an geeigneten Stellen enthält.

8. Verfahren gemäß einem beliebigen der Ansprüche 5 bis 8, wobei in einer Verfahrensweise von oben nach unten gleichzeitig jeder Chip der Vielzahl von Chips und die Packung - die durch alle auf dem Trägermedium angeordneten Chips gegeben ist - optimiert werden.

## Revendications

1. Module multipuce à couches minces à semiconducteur contenant une pluralité de puces de semiconducteur (1, 2) sur un porte-puces (3) à semiconducteur, de préférence en silicium, pour assurer une connexion de puce à puce, où
a) des contacts correspondants (111,211 ; ... ; 11n,21n ; ... ; 141,241 ; 14n,24n) de puces adjacentes (1, 2) sont disposés face à face ;
b) les dits contacts correspondants sont connectés par des lignes parallèles (11, 21, 22, 32, 42, 15) via le porte-puces à semiconducteur (3) ; et
c) des contacts d'entrée/sortie de signaux sont disposés dans des zones contiguës aux bords circonférentiels des puces ;
caractérisé en ce que les dites puces sont munies de plages de contact sur toute la surface de puce, et en ce que
la ligne extérieure de plages de contact contient des contacts d'alimentation connectés à une première couche métallique (M1) du dit porte-puces à semiconducteur, et les lignes suivantes en allant vers le centre de la puce contiennent des plages de contact d'entrée/sortie de signaux connectées à une deuxième (M2) ou une troisième (M3) couche métallique du dit porte-puces à semiconducteur.

2. Module multipuce à couches minces à semiconducteur selon la revendication 1, où toutes les plages de contact dans la zone entourée par les dites lignes suivantes de plages de contact d'entrée/sortie de signaux sont des plages de contact d'alimentation pour la masse ou la tension.

3. Module multipuce à couches mince à semiconducteur selon la revendication 1 ou 2, où chaque ligne physique qui connecte des plages de contact d'entrée/sortie de signaux est munie de lignes physiques de blindage formées par les lignes d'alimentation qui peuvent correspondre à la masse ou à la tension, spécialement en cas de connexion directe de puce à puce.

4. Module multipuce à couches minces à semiconducteur selon la revendication 3, où en cas de connexion directe de puce à puce de puces adjacentes celles-ci ne contiennent pas de circuits attaqueur/récepteur d'entrée/sortie dans les zones où sont disposés des ports d'entrée/sortie.

5. Procédé de fabrication d'un module multipuce à couches minces à semiconducteur selon l'une quelconque des revendications 1 à 4, comprenant l'étape consistant à :
concevoir les puces en exécutant les étapes consistant à :
diviser et découper logiquement en partitions le circuit à implanter sur les différentes puces de semiconducteur ;
placer ledit circuit diviser et découper en partitions sur les différentes puces de semiconducteur et simultanément sur ledit porte-puces en disposant, ainsi, les contacts d'entrée/sortie correspondant des différentes puces face à face ;
connecter les dits contacts d'entrée/sortie par des lignes parallèles via le porte-puces à semiconducteur ; et
disposer le contact d'entrée/sortie de signaux dans des zones du bord circonférentiel de la puce.

6. Procédé selon la revendication 5, où les dites puces sont encapsulées sur un porte-puces en silicium passif contenant les lignes de connexion nécessaires (S2, S3, V23) pour les puces qu'il accueille.

7. Procédé selon la revendication 6 comprenant, de plus, l'étape consistant à produire ledit porte-puces en appliquant la technique des couches minces avec essentiellement des lignes d'alimentation (6, 7) dans un premier plan (couche métallique 1, M1), un premier ensemble de lignes de signaux (S2) dans un deuxième plan (couche métallique 2, M2), un deuxième ensemble de lignes de signaux (S3) dans un troisième plan (couche métallique 3, M3), ledit premier et ledit deuxième ensemble de lignes de signaux (S2, S3) étant disposés perpendiculairement l'un à l'autre, et des traversées (V23) pour connecter aux emplacements voulus une ligne de signaux du dit premier ensemble (S2) avec une ligne de signaux du dit deuxième ensemble (S3).

8. Procédé selon l'une quelconque des revendications 5 à 8, où, selon une méthodologie descendante, chaque puce de ladite pluralité de puces et ledit boîtier - formé par toutes les puces disposées sur le porte-puces - sont optimisés simultanément.
